# EUROPÄISCHE PATENTSCHRIFT

(11) **EP 3 524 897 B1**
(45) Veröffentlichungstag und Bekanntmachung des Hinweises auf die Patenterteilung: **12.10.2022**
(21) Anmeldenummer: 18000547.2
(22) Anmeldetag: 20.06.2018
(51) Int. Cl.: F24F 13/14, H05K 7/20

(54) **LÜFTERSYSTEM**
FAN SYSTEM
SYSTÈME DE VENTILATEURS

(30) Priorität: 13.02.2018 DE 102018001140
(43) Veröffentlichungstag der Anmeldung: 14.08.2019
(73) Patentinhaber: Langmatz GmbH, 82467 Garmisch-Partenkirchen (DE)
(72) Erfinder: Nunn, Felix, 82487 Oberammergau (DE); Hutter, Michael, 82467 Unterammergau (DE)
(74) Vertreter: Flosdorff, Jürgen

(56) Entgegenhaltungen:
- DE-U1-202006 004 838
- GB-A- 1 149 873
- US-A1- 2017 055 368

## Beschreibung

Die Erfindung betrifft allgemein ein Lüftersystem mit wenigstens zwei, vorzugsweise drei oder mehr Lüftern, die in horizontaler Lage um ihre vertikale Achse drehbar nebeneinander angeordnet sind. Dabei können beispielsweise auch vier, fünf oder sechs Lüfter bzw. Ventilatoren vorgesehen sein, um beispielsweise in einer Kammer oder einer Rohrleitung einen Luftstrom zu erzeugen, der eine Anlage bevorzugt kühlt oder aber erwärmt.

Die Erfindung betrifft insbesondere einen in einen Schacht eingebauten Unterflurverteiler für elektrische und/oder elektronische Einrichtungen, die bei ihrem Betrieb unerwünschte Wärme erzeugen, die mit Hilfe des erfindungsgemäßen Lüftersystems aus dem Schacht abgeführt werden kann. Ein derartiger Unterflurverteiler ist in der EP 3 258 757 A1 offenbart.

Wenn bei einem Lüftersystem mit mehreren nebeneinander angeordneten Lüftern einer dieser Lüfter ausfällt, kann das gesamte Kühlsystem ausfallen, obwohl der andere oder die anderen Lüfter weiter Kaltluft ansaugen und an der Druckseite abgeben. Der Grund hierfür liegt darin, dass sich ein Kurzschluss der Luftströmungen zu dem ausgefallenen Lüfter einstellen kann, so dass die von den anderen Lüftern angesaugte und beförderte Kaltluft durch den still stehenden Lüfter entweicht. Die Folge kann sein, dass die zu kühlenden Elemente überhitzt und dadurch beschädigt werden können.

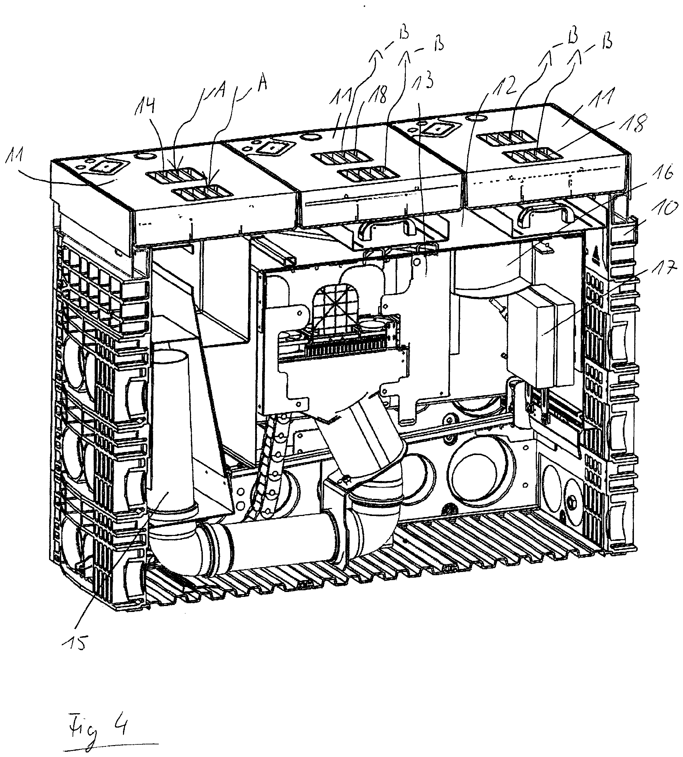

Die US2017/0055368 A1 offenbart ein Klappensystem für ein elektronisches Gerät, bei dem mehrere zu Gruppen zusammengefasste Klappen über oder unter Lüftern angeordnet sind, wobei die Klappen jeder Gruppe schwenkbar an einem Kupplungselement befestigt sind (z.B. Figur 4). Das Kupplungselement jeder Gruppe von Klappen ist ein plattenförmiges oder stabförmiges Bauteil, das als ein Gewichtselement wirkt, das eine Drehkraft auf die Klappen ausübt, so dass sich diese in die Öffnungsrichtung drehen, wie im Absatz [0053] der Druckschrift beschrieben und in Figur 7 dargestellt ist. Dies bedeutet, dass die Öffnungsstellung der Klappen durch Schwerkraft hervorgerufen wird. Wenn ein Lüfter stillsteht und ein Gegenwind der anderen Lüfter auf die geöffneten Klappen auftrifft, werden die Klappen durch diesen Gegenwind in die geschlossene Stellung gedrückt. Dies ist z.B. im Absatz [0054] der Druckschrift sowie im Absatz [0080] beschrieben.

Der vorliegenden Erfindung liegt die Aufgabe zugrunde, ein zwei oder mehr Lüfter enthaltendes Lüftersystem so auszubilden, dass auch bei Ausfall eines Lüfters das Lüftersystem weiter funktioniert.

Diese Aufgabe wird erfindungsgemäß durch die Merkmale des Patentanspruchs 1 gelöst.

Vorteilhafte Ausgestaltungen der Erfindung sind in den Unteransprüchen gekennzeichnet.

Die Erfindung ist im Anspruch 1 definiert. Sie sieht vor, dass jeder Lüfter mit einer Klappe versehen ist, die zwischen einer offenen Stellung, in der die Klappe gegenüber dem horizontal angeordneten Lüfter in einem Winkel angeordnet ist, der etwas kleiner als 90° ist, und einer geschlossenen Lage bewegbar ist, in der die Klappe den zugehörigen Lüfter an der Oberseite abdeckt, wobei die offene Stellung durch den Luftstrom des zugehörigen Lüfters und die geschlossene Stellung durch Schwerkraft hervorgerufen wird. D.h., dass die Lüfter des Lüftersystems sich automatisch öffnen, wenn die Lüfter anfangen zu rotieren. Wenn ein Lüfter ausfällt, senkt sich die Klappe durch Schwerkraft und dichtet dabei den ausgefallenen Lüfter ab, wobei das Schließen der Klappe zudem durch den Luftstrom des benachbarten Lüfters oder der benachbarten Lüfter beschleunigt wird. Auf diese Weise können die intakten Lüfter weiterhin wirkungsvoll einen kühlenden Luftstrom für nachgeordnete Bauteile wie elektrische und/oder elektronische Einrichtungen erzeugen, wenn ein redundantes Lüftersystem vorgesehen ist, das den Ausfall eines Lüfters verkraften kann.

Weiter sieht die Erfindung vor, dass die Lüfter mit einem Rahmen versehen sind, an dem die Klappen angelenkt sind. Dabei ist bevorzugt, dass benachbarte Klappen an diametral gegenüber liegenden Seiten der Lüfter angebracht sind. Weil die einzelnen Luftströme durch die Klappen ein wenig zur Seite abgelenkt werden, kann sich hierdurch ein weitgehend gleichmäßiger Luftstrom bilden.

Erfindungsgemäß hat jede Klappe einen über die Gelenke hinaus reichenden Ansatz, der in der offenen Lage der Klappe den Öffnungswinkel auf < 90° begrenzt. Der Öffnungswinkel kann 75° bis 89°, vorzugsweise 80° bis 87° und am meisten bevorzugt 80° bis 85° betragen. Eine schräge Lage der Öffnungsstellung der Klappen ist erforderlich, damit diese bei einem Ausfall eines Lüfters sich selbsttätig durch Schwerkraft schließen kann.

Außerdem ist erfindungsgemäß vorgesehen, dass an dem Ansatz der Klappen wenigstens ein Gegengewicht befestigt ist, das das Klappengewicht bestmöglichst ausgleichen soll. Bevorzugt werden als Gegengewicht Metallleisten verwendet, die an dem Ansatz befestigt werden und die die bevorzugt aus Kunststoff bestehende Klappe in einem ungefähren Gleichgewicht halten können. Das Klappengewicht sollte nur geringfügig größer als das Gesamtgewicht des Ansatzes mit daran befestigten Gegengewichten sein, wobei das Klappengewicht beispielsweise 2 g bis 10 g größer sein kann.

Die Metallleisten können an beiden Seiten des Ansatzes befestigt sein, wobei wenigstens eine Metallleiste an der dem jeweiligen Lüfter zugewandten Seite als Öffnungswinkel begrenzender Anschlag an dem Rahmen anliegen kann.

Das Lüftersystem kann in eine Kaltluft-Kammer eines in einen Schacht eingebauten Unterflurverteilers für elektrische und/oder elektronische Einrichtungen eingebaut sein und Kaltluft durch ein Rohr aus der Umgebung des Schachtes ansaugen, mit der die hinter der Kaltluft-Kammer angeordneten elektrischen und/oder elektronischen Einrichtungen durchströmt und gekühlt werden. Dabei ist es wichtig, dass dieser Kühlvorgang auch dann wirkungsvoll weiter läuft, wenn ein Lüfter ausfällt, was durch die erfindungsgemäß vorgesehenen Lüfterklappen gewährleistet ist.

Weitere Einzelheiten der Erfindung ergeben sich aus der nachfolgenden Beschreibung einer bevorzugten Ausführungsform des Lüftersystems und anhand der Zeichnungen. Dabei zeigen:
- Figur 1: das Lüftersystem mit drei Lüftern in auseinandergezogener Darstellung;
- Figur 2: das Lüftersystem mit drei geöffneten Klappen;
- Figur 3a und 3b: das Lüftersystem, bei dem jeweils eine Klappe geschlossen ist;
- Figur 4: einen Längsschnitt durch einen Unterflur in den Boden eingebauten Schacht mit einem Unterflurverteiler, in den das Lüftersystem eingebaut ist.

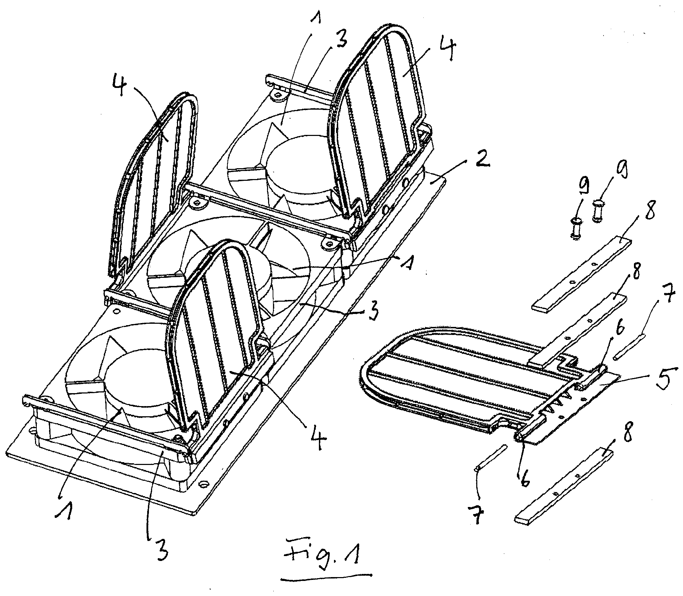

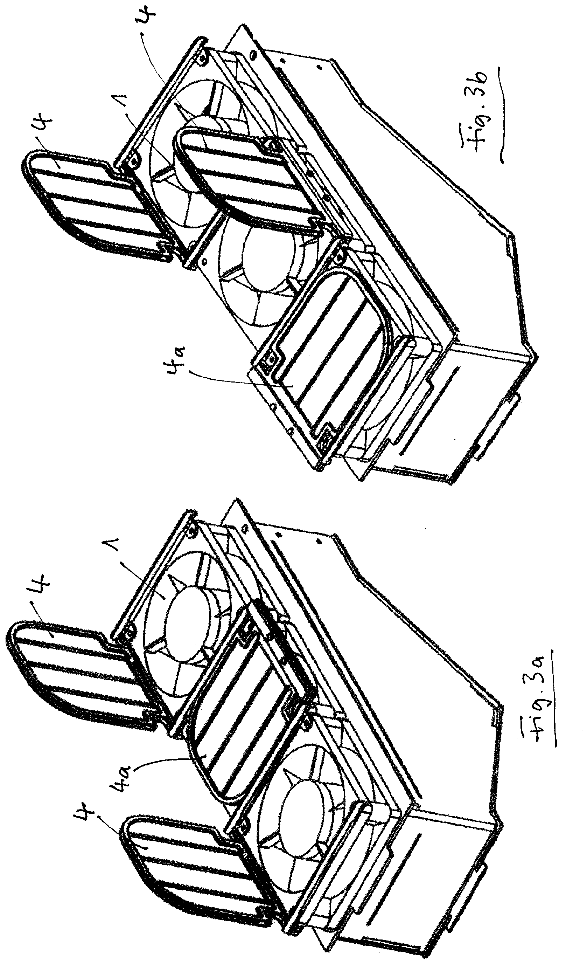

Figur 1 zeigt ein Lüftersystem mit drei nebeneinander angeordneten Lüftern 1, die horizontal angeordnet sind, so dass sie um ihre vertikale Mittelachse rotieren. Die drei Lüfter 1 sind an einer Basisplatte 2 gehalten und mit einem Rahmen 3 versehen. Jeder Lüfter 1 ist mit einer Klappe 4 versehen, die an dem Rahmen 3 angelenkt ist und zwischen einer offenen Stellung, die beispielsweise Figur 1 zeigt, und einer geschlossenen Stellung bewegbar ist, die für jeweils eine Klappe in den Figuren 3a und 3b gezeigt ist. In der offenen Stellung beträgt der Öffnungswinkel der Klappen 4 85°, d.h. die Klappen 4 befinden sich in einer gegenüber der Horizontalen leicht geneigten Lage. Die offene Stellung wird jeweils durch den von dem Lüfter erzeugten Luftstrom hervorgerufen und beibehalten. Wenn ein Lüfter 3 still steht, senkt sich die zugehörige Klappe 4 selbsttätig auf die obere Lüfteröffnung und verschließt diese, so dass kein von einem anderen Lüfter erzeugter Luftstrom durch die Öffnung des still stehenden Lüfters entweichen kann.

Die Klappen 4 bestehen aus Kunststoff und haben eine solche Form, dass sie die Lüfteröffnung in ihrem geschlossenen Zustand dicht überdecken. Die ebenen Klappen 4 haben zudem einen ebenfalls ebenen Ansatz 5, der über zwei Gelenke 6 hinaus ragt. Diese Gelenke 6 bestehen aus rohrförmigen Hülsen, in die jeweils ein überstehender querschnittlich runder Metallstift 7 fest eingesetzt ist. Die überstehenden Metallstifte 7 sitzen drehbar in Lagern des Rahmens 3, wodurch zwei scharnierartige Gelenke gebildet sind, die reibungsarm das Verschwenken der Klappen 4 ermöglichen.

An dem Ansatz 5 der Klappen 4 sind leistenförmige Gegengewichte 8 befestigt, beispielsweise mit Hilfe von Nieten 9. Bei der dargestellten Ausführungsform wird auf diese Weise eine Metallleiste 8 in der Darstellung der Figur 1 unter dem Ansatz 5 befestigt, während zwei übereinander angeordnete Metallleisten 8 auf der Oberseite angeordnet werden. Die untere Metallleiste 8 liegt in der Öffnungsstellung der Klappen 4 an dem Rahmen 3 an und begrenzt den Öffnungswinkel der Klappen 4, im vorliegenden Fall auf 85°.

Die Gewichte der Klappe 4 und das Gesamtgewicht des Ansatzes 5 jenseits der Gelenke 6 und der daran befestigten Metallleisten sind so aufeinander abgestimmt, dass die Klappe ein sehr geringes Übergewicht hat, im dargestellten Fall ein Übergewicht von 2 g, das ausreicht, um die Klappen 4 bei Ausfall einer Luftströmung selbsttätig zu schließen. Andererseits wird jede Klappe bei einsetzendem Luftstrom rasch geöffnet.

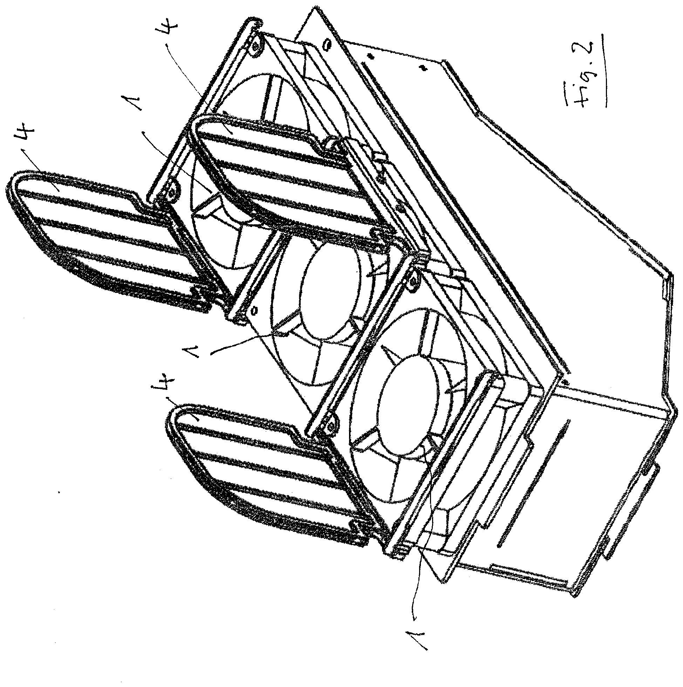

Figur 2 zeigt das Lüftersystem der Figur 1 mit drei geöffneten Klappen. Bei den Darstellungen der Figuren 3a und 3b ist jeweils eine Klappe 4a geschlossen.

Figur 4 zeigt einen Längsschnitt durch einen unterflur in den Boden eingebauten Schacht 10, der mit drei Schachtdeckeln 11 abgedeckt ist. In dem Schacht 10 ist eine unten offene Tauchglocke 12 angeordnet, die eine Kaltluftkammer 13 enthält, in die das in den Figuren 1 bis 3 dargestellte Lüftersystem eingesetzt ist. Die Lüfter 1 sind dabei in horizontaler Lage nebeneinander angeordnet. Die Lüfter 1 saugen Kaltluft aus der Umgebung des Schachtes (Pfeile A) durch Öffnungen 14 in dem in der Darstellung linken Schachtdeckel 11 und weiter durch ein Rohr 15 in die Kaltluftkammer 13 ein, von wo die durch die Lüfter 1 angesaugte Kaltluft in eine benachbarte Kammer 16 gedrückt wird, in der elektrische und/oder elektronische Einrichtungen 17 angeordnet sind, die durch den Luftstrom gekühlt werden. Die erwärmte Luft tritt unten aus der Tauchglocke 12 aus und verlässt den Schacht durch Öffnungen 18 in den beiden anderen Schachtdeckeln 11 (Pfeile B).

Bei der Darstellung der Figur 4 laufen alle drei Lüfter, deren Klappen 4 sich in der offenen Position befinden.

Es wird betont, dass die Erfindung nicht auf die beschriebenen und dargestellten Ausführungsformen beschränkt ist.

## Patentansprüche

1. Lüftersystem mit wenigstens zwei Lüftern (1), die in horizontaler Lage um ihre vertikale Achse drehbar nebeneinander angeordnet sind,
wobei jeder Lüfter (1) mit einer Klappe (4) versehen ist, die zwischen einer offenen Stellung, in der die Klappe (4) gegenüber der Vertikalen geneigt ist, und einer geschlossenen Lage, in der sie den zugehörigen Lüfter (1) überdeckt, bewegbar ist,
und wobei die Lüfter (1) von einem Rahmen (3) umgeben sind, an dem die Klappen (4) mit Gelenken (6,7) befestigt sind,
**dadurch gekennzeichnet, dass** jede Klappe (4) einen über die Gelenke (6,7) hinaus reichenden Ansatz (5) aufweist, der in der offenen Lage den Öffnungswinkel auf < 90° begrenzt, dass an dem Ansatz (5) der Klappen (4) wenigstens ein in Öffnungsrichtung wirkendes Gegengewicht (8) befestigt ist, und
dass die offene Stellung durch den Luftstrom des zugehörigen Lüfters (1) und die geschlossene Stellung durch Schwerkraft hervorgerufen wird.

2. Lüftersystem nach Anspruch 1,
**dadurch gekennzeichnet,**
**dass** der Öffnungswinkel der Klappen (4) 75° bis 89°, vorzugsweise 80° bis 87°, am meisten bevorzugt 83° bis 85°, beträgt.

3. Lüftersystem nach einem der Ansprüche 1 oder 2,
**dadurch gekennzeichnet,**
**dass** benachbarte Klappen (4) an diametral gegenüber liegenden Seiten der Lüfter (1) angebracht sind.

4. Lüftersystem nach Anspruch 1,
**dadurch gekennzeichnet,**
**dass** an beiden Seiten des Ansatzes (5) Gegengewichte (8) befestigt sind und
**dass** wenigstens ein Gegengewicht (8) an der dem jeweiligen Lüfter (1) zugewandten Seite als den Öffnungswinkel begrenzender Anschlag an dem Rahmen (3) anliegen kann.

5. Lüftersystem nach einem der Ansprüche 1 bis 4,
**dadurch gekennzeichnet,**
**dass** jede Klappe (4) mit ihrem Ansatz (5) aus Kunststoff besteht und dass die Gegengewichte (8) Metalleisten sind.

6. Lüftersystem nach Anspruch 4 oder 5,
**dadurch gekennzeichnet,**
**dass** das Klappengewicht nur einige Gramm, vorzugsweise 2g bis 10g, , größer ist als das Gesamtgewicht des Ansatzes (5) und der daran befestigten Gegengewichte (8).

7. Lüftersystem nach einem der Ansprüche 1 bis 6,
**dadurch gekennzeichnet,**
**dass** drei oder mehr Lüfter (1) nebeneinander angeordnet sind.

8. Lüftersystem nach einem der Ansprüche 1 bis 7,
**dadurch gekennzeichnet,**
**dass** das Lüftersystem in einer Kaltluft-Kammer (13) eines in einen Schacht (10) eingebauten Unterflurverteilers für elektrische und/oder elektronische Einrichtungen (17) angeordnet ist und Kaltluft durch ein Rohr (15) aus der Umgebung des Schachtes (10) ansaugt, mit der die elektrischen und/oder elektronischen Einrichtungen (17) gekühlt werden.

## Claims

1. A fan system with at least two fans (1), which are arranged next to one another in a horizontal position to be rotatable about their vertical axes, wherein each fan (1) is provided with a flap (2), which is movable between an open position, in which the flap (4) is inclined with respect to the vertical, and a closed position, in which it overlies the associated fan (1), and wherein the fans (1) are surrounded by a frame (3), to which the flaps (4) are secured with hinges (6, 7), **characterised in that** each flap (4) has a formation (5) which extends beyond the hinges (6, 7) and which, in the open position, limits the opening angle to < 90°, that fastened to the formation (5) of the flaps (4) there is at least one counterweight (8) acting in the opening direction and that the open position is produced by the airflow from the associated fan (1) and the closed position is produced by gravity.

2. A fan system as claimed in Claim 1, **characterised in that** the opening angle of the flaps (4) is 75° to 89°, preferably 80° to 87°, most preferably 83° to 85°.

3. A fan system as claimed in one of Claims 1 or 2, **characterised in that** adjacent flaps (4) are mounted on diametrically opposite sides of the fans (1).

4. A fan system as claimed in Claim 1, **characterised in that** counterweights (8) are fastened on both sides of the formation (5) and that at least one counterweight (8) can engage the frame (3) on the side directed towards the respective fan (1) as an abutment limiting the opening angle.

5. A fan system as claimed in one of Claims 1 to 4, **characterised in that** each flap (4) with its formation (5) consists of plastic material and that the counterweights (8) are metal strips.

6. A fan system as claimed in Claim 4 or 5, **characterised in that** the weight of the flaps is only a few grams, preferably 2g to 10g, greater than the total weight of the formation (5) and the counterweights (8) attached to it.

7. A fan system as claimed in one of Claims 1 to 6, **characterised in that** three or more fans (1) are arranged next to one another.

8. A fan system as claimed in one of Claims 1 to 7, **characterised in that** the fan system is arranged in a cold air chamber (13) of an underground distributor, installed in a shaft (10), for electrical and/or electronic devices (17) and draws in cold air through a pipe (15) from the surroundings of the shaft (10), with which the electrical and/or electronic devices (17) are cooled.

## Revendications

1. Système de ventilateurs avec au moins deux ventilateurs (1) qui sont agencés de manière rotative en position horizontale autour de leur axe vertical l'un à côté de l'autre,
dans lequel chaque ventilateur (1) est pourvu d'un volet (4) qui est mobile entre une position ouverte, dans laquelle le volet (4) est incliné par rapport à la verticale, et une position fermée, dans laquelle il recouvre le ventilateur afférent (1),
et dans lequel les ventilateurs (1) sont entourés par un cadre (3), auquel les clapets (4) sont fixés avec des articulations (6, 7),
**caractérisé en ce**
**que** chaque volet (4) présente une saillie (5) parvenant au-delà des articulations (6, 7) qui délimite dans la position ouverte l'angle d'ouverture à < 90°,
**qu'**au moins un contrepoids (8) agissant dans le sens d'ouverture est fixé à la saillie (5) des clapets (4), et
**que** la position ouverte est suscitée par le courant d'air du ventilateur (1) afférent et la position fermée par gravité.

2. Système de ventilateurs selon la revendication 1, **caractérisé en ce**
**que** l'angle d'ouverture des clapets (4) s'élève de 75° à 89°, de préférence de 80° à 87°, le plus préférablement de 83° à 85°.

3. Système de ventilateurs selon l'une quelconque des revendications 1 ou 2,
**caractérisé en ce**
**que** des clapets (4) contigus sont montés au niveau de côtés diamétralement opposés des ventilateurs (1).

4. Système de ventilateurs selon la revendication 1, **caractérisé en ce**
**que** des contrepoids (8) sont fixés aux deux côtés de la saillie (5) et
**qu'**au moins un contrepoids (8) peut reposer sur le côté tourné vers le ventilateur (1) respectif comme butée délimitant l'angle d'ouverture contre le cadre (3).

5. Système de ventilateurs selon l'une quelconque des revendications 1 à 4,
**caractérisé en ce**
**que** chaque volet (4) avec sa saillie (5) se compose de matière plastique et que les contrepoids (8) sont des barres métalliques.

6. Système de ventilateurs selon la revendication 4 ou 5,
**caractérisé en ce**
**que** le poids de volet est supérieur seulement de quelques grammes, de préférence de 2 g à 10 g, au poids total de la saillie (5) et des contrepoids (8) qui y sont fixés.

7. Système de ventilateurs selon l'une quelconque des revendications 1 à 6,
**caractérisé en ce**
**que** trois ventilateurs (1) ou plus sont agencés les uns à côté des autres.

8. Système de ventilateurs selon l'une quelconque des revendications 1 à 7,
**caractérisé en ce**
**que** le système de ventilateurs est agencé dans une chambre à air froid (13) d'un distributeur encastré intégré dans une cage (10) pour des systèmes (17) électriques et/ou électroniques et aspire de l'air froid par un tube (15) de l'environnement de la cage (10), avec lequel les systèmes (17) électriques et/ou électroniques sont refroidis.
